(19) Europäisches Patentamt
European Patent Office
Office européen des brevets

(11) **EP 3 677 498 B1**

(12) **EUROPEAN PATENT SPECIFICATION**

(45) Date of publication and mention of the grant of the patent:
**30.11.2022 Bulletin 2022/48**

(21) Application number: **18852396.3**

(22) Date of filing: **30.08.2018**

(51) International Patent Classification (IPC):
*B63B 25/16* (2006.01)   *B63B 25/08* (2006.01)
*B63H 21/14* (2006.01)   *B65D 88/04* (2006.01)
*F17C 13/00* (2006.01)   *F17C 13/02* (2006.01)
*G01C 21/34* (2006.01)   *G08G 3/00* (2006.01)
*F17C 3/02* (2006.01)

(52) Cooperative Patent Classification (CPC):
**F17C 9/02; B63B 25/08; B63B 25/16; B63H 21/14; B65D 88/04; G01C 21/34; G08G 3/00;**
F17C 2221/033; F17C 2223/0161; F17C 2223/033; F17C 2223/043; F17C 2223/046; F17C 2225/0123; F17C 2225/044; F17C 2250/0408;          (Cont.)

(86) International application number:
**PCT/JP2018/032124**

(87) International publication number:
**WO 2019/044975 (07.03.2019 Gazette 2019/10)**

(54) **ASSESSMENT DEVICE AND ASSESSMENT METHOD**

BEURTEILUNGSVORRICHTUNG UND BEURTEILUNGSVERFAHREN

DISPOSITIF D'ÉVALUATION ET PROCÉDÉ D'ÉVALUATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **31.08.2017   JP 2017167223**

(43) Date of publication of application:
**08.07.2020   Bulletin 2020/28**

(73) Proprietor: **Kawasaki Jukogyo Kabushiki Kaisha Kobe-shi, Hyogo 650-8670 (JP)**

(72) Inventors:
• **IWASAKI, Hidekazu**
  **Kobe-shi, Hyogo 650-8670 (JP)**
• **TAKATA, Hirotaka**
  **Kobe-shi, Hyogo 650-8670 (JP)**
• **SHINMURA, Nobuhiro**
  **Kobe-shi, Hyogo 650-8670 (JP)**

• **ANDOH, Akihiro**
  **Kobe-shi, Hyogo 650-8670 (JP)**

(74) Representative: **Leinweber & Zimmermann Patentanwalts-PartG mbB European Patent Attorneys Viktualienmarkt 8 80331 München (DE)**

(56) References cited:
**JP-A- S4 985 778      JP-A- H08 318 899
JP-A- S56 120 485      JP-A- S56 120 485
JP-A- S62 199 588      JP-A- 2015 175 488**

**(Cont. next page)**

EP 3 677 498 B1

(52) Cooperative Patent Classification (CPC): (Cont.)
F17C 2250/0439; F17C 2250/0491;
F17C 2250/0631; F17C 2260/02; F17C 2265/032;
F17C 2265/066; F17C 2270/0105; Y02T 70/5218

## Description

## Technical Field

The present invention relates to an assessment device and an assessment method of operation for a liquefied gas carrying vessel.

## Background Art

A liquefied gas carrying vessel (liquefied natural gas (LNG) carrying vessel) needs to keep a tank temperature at or below a prescribed temperature during a ballast voyage after the LNG is transferred to the land (after unloading). Therefore, an operation of spraying LNG is performed to cool the tank. Further, the LNG in a tank and/or boil-oif gas obtained by boiling off the LNG are used as fuel for navigating the LNG carrying vessel. For this reason, it is necessary to keep a certain amount of LNG in the tank remained before the ballast voyage (at an unloading place). The LNG left in the tank in this way is called heel. It is necessary to set an amount of heel in the ballast voyage in consideration of an amount of LNG required for the spray operation and the fuel supply operation.

Here, an optimum route calculation for vessels including the LNG carrying vessels has been given the most importance as effective means in operation management of the vessels, in view of reduction of operating costs caused by soaring fuel prices, reduction of greenhouse gas (GHG) emissions, and further, increasing needs for safe operation and maintaining and improving transport quality (for example, refer to PTL 1 described below). In order to reduce the transportation cost and improve the transportation efficiency, it is desired that the LNG in the tank of the LNG carrying vessel be unloaded at the unloading place as much as possible to navigate the return route (ballast voyage) with the minimum amount of heel. Therefore, with the development of the above optimum route calculation method, when the accuracy of predicting the amount of LNG used in operations using the LNG increases, such as in the spray operation and the fuel supply operation, the amount of heel during the ballast voyage is expected to be set at the minimum necessary.

## Citation List

**Patent Literature** Document JP2015 175488 discloses a LNG tanker with a tank cool down spray system and data collecting system.

## Summary of Invention

## Technical Problem

However, if the amount of heel is too small, a problem caused by deterioration of the stored LNG tends to become apparent. LNG is composed of plural components such as methane, ethane, propane, and butane, and each component has a different boiling point (saturation temperature). Therefore, when the LNG is sprayed in the tank to prevent the tank temperature from gradually rising, among the LNG being sprayed, methane being a component with the low saturation temperature boils off. However, ethane, propane, butane, or the like having a larger specific gravity and a higher saturation temperature than methane return to heel as a liquid without boiling off too much. For this reason, a component composition of the LNG remaining in the heel becomes heavier, and the saturation temperature of the entire heel gradually increases (heel becomes difficult to boil off).

As a result, the temperature of heel gradually increases, and the temperature of the tank does not easily decrease even when the spraying is performed (reduction of spray cooling effect). In addition, as the heel becomes heavier, the ratio of ethane, propane, and butane in the boil-off gas generated by the spraying increases, causing knocking to occur more easily depending on the engine, and accordingly, the LNG and/or the boil-off gas obtained by boiling off the LNG cannot be used for the fuel.

In formulating an operation plan for the LNG carrying vessel based on the optimum route calculation, the above-mentioned problem due to the LNG deterioration has not been considered so far, and it has been difficult to accurately predict various operations performed using LNG during the ballast voyage of the LNG carrying vessel.

The present invention has been made in view of the above, and an object of the present invention is to provide an assessment device and an assessment method that can easily assess an effect of an operation performed using liquefied gas during a ballast voyage of a liquefied gas carrying vessel.

## Solution to Problem

According to one aspect of the present invention, the above object is achieved by an assessment device according to claim 1.

According to the above configuration, by calculating the spray limit index based on the change in the liquid temperature at the bottom of the tank before and after the spray operation is performed in the tank, a degree of heaviness of heel is predicted. This makes it possible to easily assess the effect of the operation performed using the liquefied gas during the ballast voyage of the liquefied gas carrying vessel.

The assessment device may include a simulation execution unit that executes, using an initial amount of heel indicating an amount of the liquefied gas stored in the tank at a departure place of the ballast voyage, a simulation of the spray operation using the spray mechanism in a route from the departure place to an arrival place of the ballast voyage. Further, when the spray limit index falls outside the range before arrival at the arrival place in the simulation, the simulation execution unit may be configured to continue the simulation after changing a subsequent operation mode of the spray mechanism. With this configuration, the effectiveness of the spray operation can be determined.

The assessment device may include a simulation execution unit that executes, using an initial amount of heel indicating the amount of the liquefied gas stored in the tank at a departure place of the ballast voyage, a simulation of the spray operation using the spray mechanism in a route from the departure place to an arrival place of the ballast voyage. Further, when the spray limit index falls outside the range before arrival at the arrival place in the simulation, the simulation execution unit may be configured to increase the initial amount of heel and re-execute the simulation. With this configuration, it is possible to determine in advance whether the initial amount of heel is the minimum (optimum).

The spray limit index calculation unit calculates, as the spray limit index, a difference between an amount of change in liquid temperature per unit time of the liquefied gas before the spray operation of the liquefied gas and an amount of change in liquid temperature per unit time of the liquefied gas after the spray operation of the liquefied gas. By calculating and comparing the amount of change in liquid temperature per unit time at the bottom of the tank before and after the spraying is performed in the tank, it is possible to appropriately predict the degree of heaviness of heel.

The liquefied gas carrying vessel may include plural tanks, and at least one of the plural tanks may be a non-heel tank that stores only a minimum required amount of the liquefied gas during the ballast voyage. Further, the spray limit index calculation unit may calculate the spray limit index based on a liquid temperature of the liquefied gas at a bottom of the non-heel tank. By simulating the change in temperature in the non-heel tank in which the amount of heel stored in the tank is small from the beginning, it is possible to detect with high accuracy the change in liquid temperature caused by the heel becoming heavy.

The liquefied gas carrying vessel may include plural tanks, and at least two of the plural tanks may be heel tanks that store the liquefied gas used for navigation of the liquefied gas carrying vessel in the ballast voyage. Further, the spray mechanism may be configured to supply liquefied gas being sprayed in each tank from at least one of the at least two heel tanks, and when the spray limit index falls outside the range, the assessment device may switch the heel tank as a supply source of liquefied gas to be sprayed in each tank to another heel tank. Thus, when the plural tanks are set as the heel tanks, the supply source of the liquefied gas can be switched at an optimum timing.

The assessment device may stop the spray operation performed subsequently when the spray limit index falls outside the range. Thus, it is possible to prevent the spray operation by which the effect cannot be expected from continuing.

The liquefied gas carrying vessel may include a premixed combustion gas engine that can use the liquefied gas stored in the tank as fuel. Further, the assessment device may include a methane number calculation unit that calculates a composition change of the liquefied gas stored in the tank and a boil-off gas in the tank after the spray operation of the liquefied gas is performed using the spray mechanism, and calculates a methane number of the liquefied gas and the boil-off gas. Still further, the assessment unit may be configured to assess whether or not the methane number of the liquefied gas after the spray operation of the liquefied gas is performed falls outside a prescribed range.

According to the above configuration, an amount of composition change of the boil-off gas and the liquefied gas (heel) stored in the tank after the spray operation is performed is calculated, and the methane number of the boil-off gas and the heel is calculated, whereby the degrees of heaviness of the boil-off gas and the heel are predicted. Therefore, it can be easily assessed whether or not the liquefied gas in the tank can be used as the fuel for the premixed combustion gas engine. Therefore, the effectiveness of the fuel supply operation can be determined in addition to the effectiveness of the spray operation.

The assessment device may include a simulation execution unit that executes, using an initial amount of heel indicating an amount of the liquefied gas stored in the tank at a departure place of the ballast voyage, a simulation of the spray operation using the spray mechanism in a route from the departure place to an arrival place of the ballast voyage. Further, when the methane number falls outside the range before arrival at the arrival place in the simulation, the simulation execution unit may be configured to continue the simulation after changing a subsequent supply mode of the liquefied gas to the premixed combustion gas engine. With this configuration, the effectiveness of the fuel supply operation can be determined in advance in addition to the effectiveness of the spray operation.

The assessment device may include a simulation execution unit that executes, using an initial amount of heel indicating an amount of the liquefied gas stored in the tank at a departure place of the ballast voyage, a simulation of the spray operation using the spray mechanism in a route from the departure place to an arrival place of the ballast voyage. Further, when the methane number falls outside the range before arrival at the arrival place in the simulation, the simulation execution unit may be configured to increase the initial amount of heel and re-execute the simulation. With this configuration, it can be determined whether the initial amount of heel is the minimum (optimum).

According to another aspect of the present invention, an assessment method according to claim 10 is provided.

According to the above method, by calculating the spray limit index based on the change in the liquid temperature at the bottom of the tank before and after the spray operation is performed in the tank, a degree of heaviness of heel is predicted. This makes it possible to easily assess the effect of the operation performed using the liquefied gas during the ballast voyage of the liquefied gas carrying vessel.

## Advantageous Effects of Invention

According to the present invention, it is possible of easily assess the effect of an operation performed using the liquefied gas during the ballast voyage of the liquefied gas carrying vessel.

## Brief Description of Drawings

FIG 1 is a block diagram showing a schematic configuration of an assessment device according to one embodiment of the present invention.

FIG 2 is a schematic configuration diagram showing an example of a propulsion system of a liquefied gas carrying vessel being a target of the assessment device shown in FIG 1.

FIG. 3 is a diagram showing a schematic configuration of a fuel gas supply system of the liquefied gas carrying vessel shown in FIG 2.

FIG 4 is a graph showing a temporal change in a 0% position liquid temperature of a non-heel tank.

## Description of Embodiment

Hereinafter, an embodiment of the present invention is described in detail with reference to the drawings. In the following, the same or corresponding elements are denoted by the same reference symbols throughout all the drawings, and redundant descriptions are omitted.

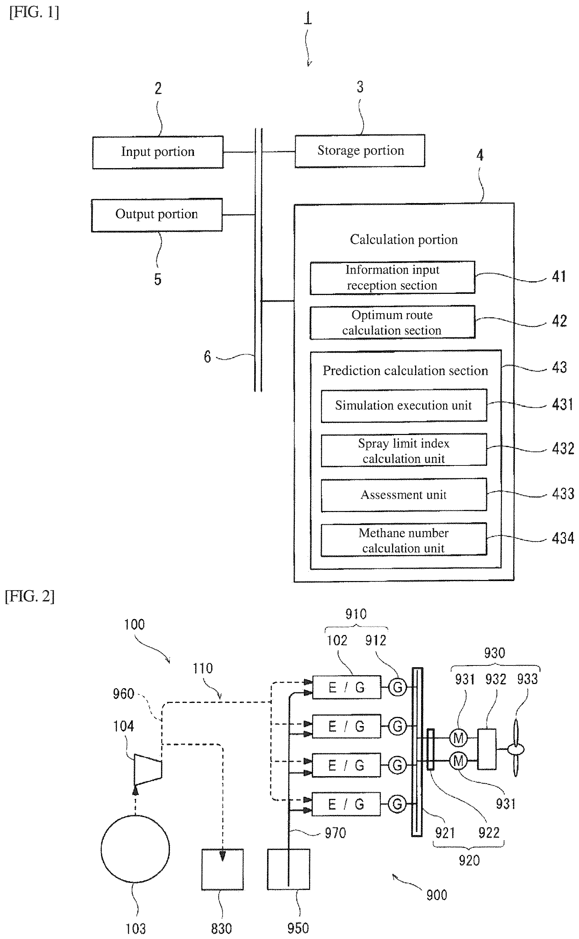

FIG 1 is a block diagram showing a schematic configuration of an assessment device according to one embodiment of the present invention. The assessment device 1 shown in FIG 1 includes an input portion 2, a storage portion 3, a calculation portion 4, and an output portion 5. Each of the components 2 to 5 of the assessment device 1 mutually transmit data via a bus 6. The assessment device 1 may be configured with a computer in a ground facility, or may be configured as a computer or a control device installed on a liquefied gas carrying vessel (LNG carrying vessel). In addition, a configuration may be made in which some of the functions that constitute the assessment device 1 are exerted by a computer installed on the LNG carrying vessel, and other functions are exerted by a computer installed on the ground, and data is mutually communicated using communicators such as a ship-to-ground communication.

The input portion 2 is configured as an input device that allows a user to input information such as a departure place, an arrival place, a departure time, and an arrival time of the LNG carrying vessel. Furthermore, the information input from the input portion 2 includes an amount of heel of liquefied gas (LNG) stored in a tank of the LNG carrying vessel (initial amount of heel), an LNG composition (initial composition), an LNG liquid temperature (initial liquid temperature), and a tank pressure (initial tank pressure), and the like, at the departure place of a ballast voyage (unloading place of LNG). The storage portion 3 stores information input from the input portion 2. The storage portion 3 stores, in advance, performance data of the LNG carrying vessel, weather data of at least a route area where the LNG carrying vessel navigates, and various calculation programs such as a prediction calculation program and an optimum route calculation program, which are described later.

The performance data of the LNG carrying vessel is data on the performance that each LNG carrying vessel has individually. The weather data is provided from, for example, an external organization. The weather data is, for example, data on weather (sea weather) in the route area or the like one week ahead of the present time. Note that a configuration may be made in which the weather data is sequentially transmitted from the outside through a network, and is automatically stored in the storage portion 3.

The calculation portion 4 executes optimum operation plan calculation processing for calculating an optimum route of the LNG carrying vessel and an optimum operation plan including various operation controls on the route based on the various pieces of information stored in the storage portion 3. The optimum operation plan is created by adding a concept of time (preferred values such as departure time, arrival time, time at a prescribed position on the route, and stop time at a prescribed position on the route) to the optimum route, and including the execution necessity of various operations at each time.

To this end, the calculation portion 4 exerts the functions of an information input reception section 41, an optimum route calculation section 42, a prediction calculation section 43, and the like by appropriately executing the optimum route calculation program, the prediction calculation program, and the like.

The information input reception section 41 receives input of information including the departure place, the arrival place, the departure time, the arrival time, the initial amount of heel, the initial composition, the initial liquid temperature, the initial tank pressure, and the like of the LNG carrying vessel 100. The optimum route calculation section 42 calculates the optimum route based on the input information, the performance data of the vessel stored in the storage portion 3, and the weather data of the route area where the vessel travels. The optimum route calculation section 42 can execute an optimum route calculation by, for example, the dynamic programming (DP) method, the calculus of variations, the Dijkstra method, the A-star method, or the isochronous curve method. The optimum route calculation section 42 calculates as an optimum route, for example, a route that minimizes an evaluation function of parameters related to navigation safety such as wave height and hull vibration based on the weather data and fuel efficiency based on the performance data of the vessel.

The prediction calculation section 43 executes an execution prediction calculation of an operation performed using LNG during the ballast voyage of the LNG canying vessel. For this reason, the prediction calculation section 43 exerts the functions of a simulation execution unit 431, a spray limit index calculation unit 432, an assessment unit 433, a methane number calculation unit 434, and the like. The details are described later.

The output portion 5 outputs a calculation result of the calculation portion 4. For example, the output portion 5 displays the optimum operation plan calculated by the calculation portion 4 on a map (nautical chart) on a display device (not shown) connected to the assessment device 1. Further, the output portion 5 may display, on the map, a point where spray control is executed, and may display a list of temperature changes before and after the execution of the control.

[Example of LNG carrying vessel]

Hereinafter, a configuration of the LNG carrying vessel to be subjected to effect assessment processing in the present embodiment is described. FIG 2 is a schematic configuration diagram showing an example of a propulsion system 900 of the liquefied gas carrying vessel (LNG carrying vessel) 100 being a target of the assessment device shown in FIG 1. The LNG carrying vessel 100 shown in FIG 2 employs a dual-fuel diesel (DFD) electric propulsion system as the propulsion system 900.

The propulsion system 900 of the LNG carrying vessel 100 includes a power generation unit 910, a propulsion unit 930 driven by the power generated by the power generation unit 910, and a power distribution and control unit 920 provided in a power supply system from the power generation unit 910 to the propulsion unit 930. The power generation unit 910 includes plural sets of a power generation engine 102 and a power generator 912, and the like. Mechanical energy generated by the engine 102 is extracted as electric power by the power generator 912.

The propulsion unit 930 includes at least one propulsion motor 931, a propulsion device 933 driven by the output of the propulsion motor 931, a reduction gear 932 provided on a power transmission path from the propulsion motor 931 to the propulsion device 933, and the like. The power distribution and control unit 920 includes a power distribution panel 921 for distributing electric power from the power generation unit 910, an inverter 922 for controlling the output (i.e., rotation speed) of the propulsion motor 931, and the like. However, the thrust may be adjusted by setting a rotation speed of the propulsion motor 931 to be constant and changing a pitch using a variable pitch propeller.

The rotation speed of the propulsion motor 931 is determined, for example, by an amount of operation of a maneuvering device such as a not-shown telegraph lever, and power equivalent to a required power value corresponding to the rotation speed is supplied from the power distribution and control unit 920 to the propulsion unit 930. In this way, an amount of fuel corresponding to an amount of power generation is supplied to the power generation unit 910 so that the power generated by the power generation unit 910 is sufficient for the power used by auxiliary equipment, onboard equipment, and the like, in addition to the power used by the propulsion unit 930.

In the propulsion system 900 having the above configuration, the engine 102 is a dual-fuel four-cycle diesel engine that can bum oil and gas. Therefore, the fuel supply system to the engine 102 includes a fuel gas (premixed combustion gas) supply system 960 for supplying fuel gas to the engine 102, and a fuel oil supply system 970 for supplying fuel oil such as heavy oil stored in a fuel oil tank 950 to the engine 102. In FIG 2, the fuel gas supply system 960 is indicated by a dashed arrow, and the fuel oil supply system 970 is indicated by a solid arrow. The fuel gas supply system 960 is constituted of a fuel gas supply system 110 that supplies, to the engine 102, gas produced by having the liquefied gas in a liquefied gas transport tank 103 naturally boiled off (hereinafter, referred to as "NBOG"), and/or forced boil-off gas produced by having the liquefied gas in the tank 103 forcibly boiled off (hereinafter, referred to as "FBOG"). Hereinafter, the fuel gas supply system 110 is described in detail.

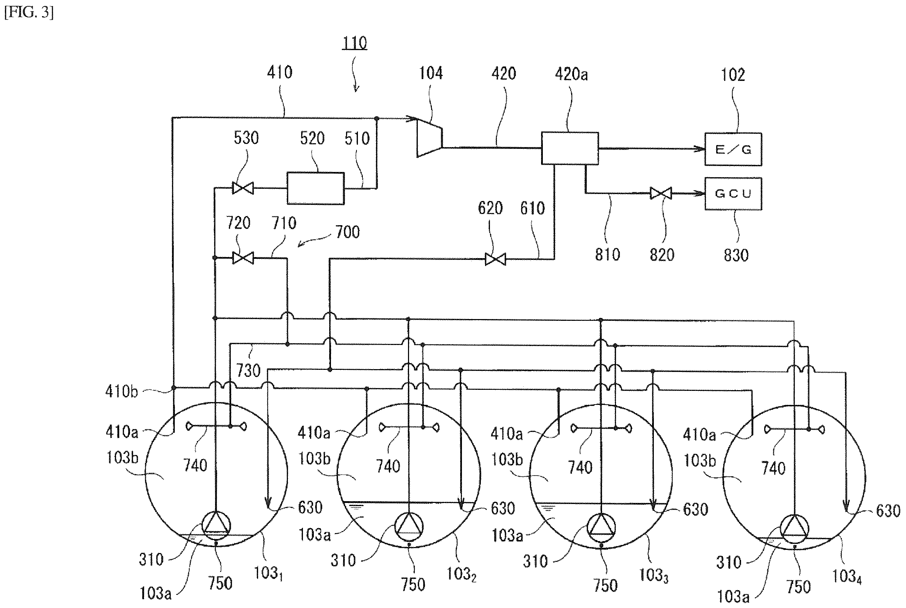

FIG 3 is a diagram showing a schematic configuration of the fuel gas supply system 110 of the liquefied gas carrying vessel shown in FIG 2. The LNG carrying vessel 100 is provided with the plural large tanks 103 arranged in a vessel length direction, and the four tanks 103 are shown in FIG 3. Therefore, in FIG 3 and the following description, each of the plural tanks is referred to as the tank $103_i$ (i = 1, 2, 3, 4). The tank $103_i$ has heat insulating properties that can maintain a cryogenic state so that LNG can be maintained in a liquid state at about - 162°C under atmospheric pressure

The fuel gas supply system 110 shown in FIG 3 includes the tanks $103_i$ (i = 1, 2, 3, 4) storing the liquefied gas, a compressor 104 having a variable amount of discharge, boil-off gas lines 410 that guide NBOG generated in the tanks $103_i$ to the compressor 104, and a fuel gas supply line 420 that guides to the engine 102 the fuel gas (premixed combustion gas) in which gas containing NBOG is compressed by the compressor 104.

In the tank $103_i$, a liquid phase portion 103a is on the lower side and a gas phase portion 103b is on the upper side, with a liquid surface of the stored LNG interposed therebetween, and the gas phase portion 103b contains gas containing NBOG The tank $103_i$ is provided with a liquid level meter (not shown) for detecting a liquid level of LNG in the tank $103_i$.

In general, the LNG carrying vessel 100 has different ratios of the liquid phase portion 103a and the gas phase portion 103b in the tank $103_i$, regarding the time of navigating from a gas production place to a gas consumption place (unloading place) (laden voyage), and the time of navigating from the gas consumption place to the gas production place (ballast voyage). For example, when the LNG canying vessel 100 travels from the gas production place to the gas consumption place, the tank $103_i$ is filled with the liquefied gas. For example, a state in which the liquid phase portion 103a of the LNG occupies about 98.5% or more of a tank capacity is regarded as "full load". When the LNG carrying vessel 100 navigates from the gas consumption place to the gas production place, a small amount of LNG is accommodated in the tank 103. For example, a state in which the liquid phase portion 103a of the LNG is about 1.5% or less of the tank capacity is referred to as "empty load". During the navigation of the LNG carrying vessel 100, the ratio of the liquid phase portion 103a and the gas phase portion 103b fluctuates slightly as the LNG evaporates in the tank $103_i$.

The boil-off gas line 410 is constituted of at least one pipe connecting a gas inlet port 410a opening at an upper part of each tank $103_i$ and an inlet of the compressor 104. The NBOG in the tank $103_i$ is guided to the compressor 104 by the boil-off gas line 410. In the present embodiment, the boil-off gas lines 410 connected to the respective tanks $103_i$ are bundled together at a vapor gas header 410b, and on the downstream side of the vapor gas header 410b of the boil-off gas line 410, the LNG flowing out of each of the tanks $103_i$ joins and flows to the compressor 104. Although not shown, a pre-cooler that cools gas flowing into the compressor 104, a mist separator that removes moisture from the gas flowing into the compressor 104, and the like are provided downstream of the vapor gas header 410b of the boil-off gas line 410.

To the boil-off gas line 410, there is connected the downstream end of a forced boil-off gas line 510 that guides the LNG in the tank 103 to the compressor 104. The forced boil-off gas line 510 is provided with a pump 310 arranged in the liquid phase portion 103a in the tank 103, a boil-off device 520, and a forced boil-off valve 530 for controlling a flow rate of LNG flowing into the boil off device 520, and the above components are connected by piping or the like. In the forced boil-off gas line 510, the LNG in the tank $103_i$ is pumped to the boil-off device 520 by the operation of the pump 310, and FBOG in which the LNG is forcibly boiled off by the boil off device 520 is sent to the compressor 104.

The compressor 104 is a device that pressure-feeds the gas introduced from the upstream side to the downstream side. NBOG and/or FBOG taken into the compressor 104 is compressed and discharged to the fuel gas supply line 420. NBOG and/or FBOG thus compressed are used in the engine 102 as fuel gas. The compressor 104 according to the present embodiment is a low-duty compressor and is configured, for example, to intake gas at approximately atmospheric pressure, increase the pressure to about 500 kPa ($\approx$ 5 bar), which is a required pressure of the engine 102, and discharge the gas. The compressor 104 according to the present embodiment is, for example, an axial flow type or centrifugal type compressor, or the like, and is configured to vary an amount of discharge (or an amount of intake) by adjusting a degree of opening of a suction port and/or a rotation speed of a motor.

The fuel gas supply line 420 includes at least one or more pipes connecting a discharge port of the compressor 104 and an inlet of the engine 102. The fuel gas supply line 420 is provided with a gas header 420a having a larger flow path cross-sectional area than other portions. The fuel gas supply line 420 branches off from the gas header 420a on the downstream side and the branched lines are connected to the plural engines 102. FIG 3 shows only one of the plural engines 102.

A return line 610 for returning gas from the fuel gas supply line 420 to the tank $103_i$ is connected to the fuel gas supply line 420. An upstream end of the return line 610 according to the present embodiment is connected to the gas header 420a. The downstream end 630 of the return line 610 is located in the tank 103. In the present embodiment, the return line 610 is connected to each of the tanks $103_i$, and is configured so that the fuel gas is returned from the fuel gas supply line 420 to each of the tanks 103. However, the return line 610 may be configured such that the gas returns to at least one of the plural tanks 103.

The return line 610 is provided with a return valve 620 having a variable opening so that the flow path cross-sectional area of the return line 610 becomes variable. By controlling a degree of opening of the return valve 620, pressure of the gas header 420a is controlled so as to fall within an allowable range of the engine 102.

Further, an exhaust line 810 that guides gas to a gas combustion unit (GCU) 830 is connected to the fuel gas supply line 420. An upstream end of the exhaust line 810 according to the present embodiment is connected to the gas header 420a The gas combustion unit 830 combusts the gas guided from the fuel gas supply line 420 via the exhaust line 810 and exhausts the gas to the outside of the LNG carrying vessel 100. The exhaust line 810 is provided with an exhaust valve 820.

Further, the LNG carrying vessel 100 has a spray mechanism 700 that sucks out a part of LNG in the tank $103_i$ and sprays the LNG in the tank $103_i$. The spray mechanism 700 includes the pump 310 arranged at the bottom of the tank $103_i$, a collecting line 710 arranged outside the tank $103_i$, a spray adjusting valve 720 for controlling a flow rate of LNG flowing into the collecting line 710, a spray line 730 extending into the tank $103_i$, and a spray nozzle 740 provided at a tip of the spray line 730 inside the tank $103_i$.

In the present embodiment, piping between the pump 310 and the collecting line 710 is shared with the forced boil-off gas line 510. That is, the collecting line 710 is provided so as to branch off from the forced boil-off gas line 510. The spray mechanism 700 performs a spray operation of injecting the LNG stored in the tank $103_i$ into the tank $103_i$ via the pump 310, the collecting line 710, the spray line 730, and the spray nozzle 740.

The spray nozzle 740 is configured so that plural nozzles having different degrees of opening can be switched from each other. Instead of this, a configuration may be made in which the degree of opening of one nozzle can be adjusted like in a variable valve, or plural nozzles are provided and opening portions of a part of the nozzles are blocked to allow the degree of opening to be adjusted.

The spray operation is performed during the ballast voyage when the liquid phase portion 103a of LNG is low. During the ballast voyage, the amount of LNG (liquid phase portion 103a, or heel) stored in the tank $103_i$ is small. Therefore, the temperature of the tank $103_i$ and the gas temperature in the tank $103_i$ increase due to heat entering from outside the tank $103_i$. The spray operation is performed to prevent or suppress this. For this reason, for example, the spray operation is performed when an equatorial temperature of the tank $103_i$ (temperature at the center in the height direction of the tank $103_i$) is a prescribed temperature or higher (for example, -110°C, that is, for example, +50°C of the temperature of the liquid phase portion 103a).

Among the plural pumps 310, one pump 310 operates in the spray operation. That is, one tank $103_i$ of the plural tanks $103_i$ (for example, $103_2$) serves as a supply source of LNG for the spray operation. For example, in the LNG carrying vessel 100, at least one of the plural tanks $103_i$ is a non-heel tank in which only the minimum amount of LNG is stored during the ballast voyage. In the example of FIG 3, two tanks $103_1$ and $103_4$ of the four tanks $103_i$ are set as non-heel tanks. The non-heel tanks $103_1$ and $103_4$ are in a state in which the LNG that could not be completely sucked out by the pump 310 has remained as a result in the tank at the unloading place.

On the other hand, the remaining tanks $103_2$ and $103_3$ store the LNG (heel) used for the navigation of the LNG carrying vessel 100 and the spray operation, and these tanks are hereinafter referred to as heel tanks. The heel tanks $103_2$ and $103_3$ also become a source of LNG for the spray operation.

An amount of spraying in the spray operation is adjusted by adjusting the power supplied to the pump 310 and the degree of opening of a valve (not shown) set downstream of the pump 310 to adjust the pump output, by adjusting the time of ejecting the LNG from the spray nozzle 740, and/or by adjusting the degree of opening of the spray nozzle 740.

As described above, the spray operation is performed to prevent or suppress the increase in temperature of the tank $103_i$ and gas temperature in the tank $103_i$. The boil-off gas generated by the spray operation is consumed by being supplied to the engine 102 as fuel. However, when a tank pressure exceeds an allowable pressure in a state of the consumption of boil-off gas in the engine 102 being small and the amount of boil-off gas generated by the spray operation being large, the excess boil-off gas is sent from the tank $103_i$ to the gas combustion unit 830. Then, the excess boil-off gas is burned and exhausted in the gas combustion unit 830. Thus, the excess boil-off gas is wasted. Further, there is a limit to the amount of boil-off gas to be treated in the gas combustion unit 830. Therefore, the spray operation needs to be optimized so as not to emit excess boil-off gas.

[Effect assessment processing]

As described above, during the ballast voyage of the LNG carrying vessel 100, the LNG is used in performing the spray operation and the fuel supply operation for supplying fuel to the engine 102. It is necessary to set an amount of heel in the ballast voyage in consideration of an amount of LNG required for the spray operation and the fuel supply operation. The prediction calculation section 43 of the assessment device 1 executes a prediction calculation of the above operations during the ballast voyage of the LNG carrying vessel 100. In addition, the assessment device 1 assesses the effect of the above operations based on a result of the prediction calculation of the operations.

[Effect assessment processing related to spray operation]

First, the effect assessment processing regarding the spray operation is described. First, the prediction calculation section 43 predicts a temperature change in the tank $103_i$ from the optimum route calculated by the optimum route calculation section 42 and weather data on the optimum route. Then, the simulation execution unit 431 simulates the spray operation of the spray mechanism 700 on the route from the departure place to the arrival place of the ballast voyage using an initial amount of heel that is input. At this time, the simulation execution unit 431 executes prediction calculation on an amount of spraying in a case of performing the spray operation according to a change in temperature of the tank $103_i$ and a change in gas temperature in the tank $103_i$, on a change in temperature of the tank $103_i$ and a change in gas temperature in the tank $103_i$ by the spray operation (suppression effect), a state of heel used for spraying, and the like.

In order to predict the change in state of the heel according to the spray operation in the simulation, the spray limit index calculation unit 432 calculates a spray limit index indicating a change in liquid temperature of the LNG at the bottom of the tank caused by the spray operation of LNG (hereinafter, also referred to as a 0% position liquid temperature). That is, as shown in FIG 3, when it is assumed that a virtual temperature measuring device 750 is provided at the bottom of the tank $103_i$, a change in temperature measured by the temperature measuring device 750 is simulated.

In addition, the temperature measuring device 750 may be actually provided at the bottom of the tank $103_i$ of the LNG carrying vessel 100, or a liquid thermometer normally installed at a 0% liquid level position may be used instead, to execute the simulation based on the measurement data.

In the present embodiment, the spray limit index calculation unit 432 calculates the spray limit index based on the liquid temperature of LNG at the bottom of the non-heel tanks $103_1$ and $103_4$. For example, the spray limit index calculation unit 432 calculates a difference between dT1/dt, which is an amount of change in liquid temperature (0% position liquid temperature) of LNG per unit time before the spray operation of LNG and dT2/dt, which is an amount of change in liquid temperature (0% position liquid temperature) of LNG per unit time after the spray operation of LNG, as the spray limit index SLI (= dT2/dt - dT1/dt).

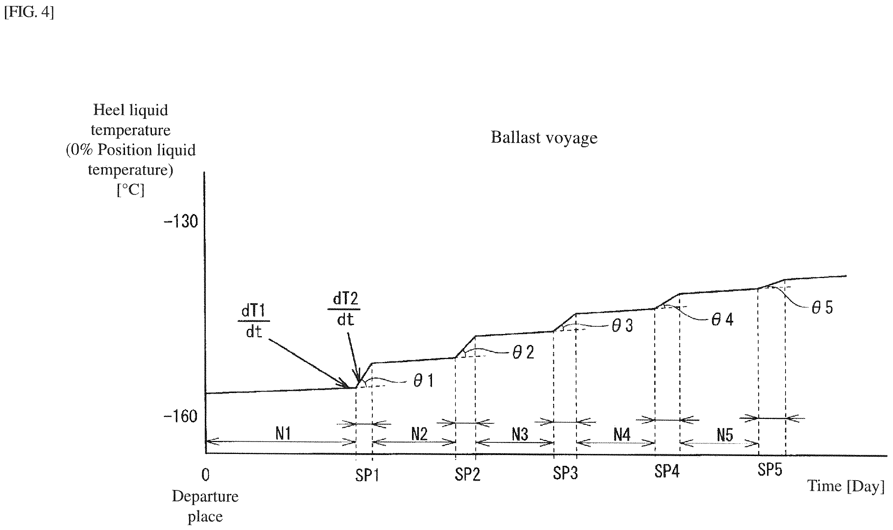

The meaning of the spray limit index SLI is described in detail. FIG 4 is a graph showing a temporal change in liquid temperature at the 0% position liquid temperature of the non-heel tank. A position where a time axis being the horizontal axis is 0 corresponds to the departure time of the ballast voyage. In the ballast voyage, the equatorial temperature of the tank $103_i$ increases while the 0% position liquid temperature gradually increases after the navigation is started from the departure place and before the spray operation is performed (period N1). When the equatorial temperature becomes a prescribed temperature or higher, the spray operation is performed. At this time, the heel LNG stored in the heel tank (for example, tank $103_2$) is sucked up by the pump 310 and sprayed from each spray nozzle 740 of each tank $103_i$.

In the spray operation, among the components of LNQ methane (saturation temperature of -161.5°C, density of 0.656 $kg/m^3$ at normal pressure) having a low specific gravity mainly boils off However, the remaining components having a large specific gravity such as ethane (saturation temperature of -89°C, density of 1.36 $kg/m^3$ at normal pressure), propane (saturation temperature of -42°C, density of 2.01 $kg/m^3$ at normal pressure), butane (saturation temperature of -1°C, density of 2.48 $kg/m^3$ at normal pressure), hardly boil off because the saturation temperature is high, and fall into the heel of the tank $103_i$ while remaining as droplets.

When the remaining components fall, the unboiled off droplet comes into contact with the gas phase portion 103b in the tank $103_i$, and the temperature of the droplet itself increases. When the unboiled off droplet falls into the heel in this state, the droplet sinks to the bottom of the tank $103_i$ because of its higher density than the heel originally stored in the tank $103_i$, and the heel temporarily becomes two-layered by having an original liquid layer and a layer of heavy components formed by falling droplets. As a result, the 0% position liquid temperature becomes dominant to the unboiled off droplets that have fallen, and the 0% position liquid temperature increases more rapidly than before. During the spray operation (period SP1), the heavy component, which becomes the droplets, continuously fall and accumulate at the bottom of the heel, so that the temperature continues to increase.

When the spray operation is completed, the heated droplets do not fall any longer, and accordingly, the 0% position liquid temperature does not rapidly increase any longer. Then, because the two-layered heel is mixed by convection, the heel becomes single-layered.

After the end of the spray operation, the 0% position liquid temperature increases gradually as in the case before the spray operation (period N2). By repeating the spray operation (by repeating the period Nj (j = 1,2,...) and the period SPj alternately), the equatorial temperature of the tank $103_i$ is maintained at a prescribed temperature or below, or the temperature gradually decreases toward the prescribed temperature. However, while the 0% position liquid temperature of the non-heel tank $103_1$ and $103_4$ gradually increases, a change occurs in which the 0% position liquid temperature rapidly increase every time the spray operation is performed.

However, when the spray operation is repeated, the liquid temperature of the entire heel increases, and when the spray operation is performed, a difference between the liquid temperature of the heel sprayed from the spray nozzle 740, and the equatorial temperature of the tank $103_i$ and the temperature of the gas phase portion 103b becomes smaller. As a result, even when the unboiled off droplets come into contact with the gas phase portion 103b in the tank $103_i$ by the spray operation, the temperature increase becomes small. Further, because the temperature of the heel itself also increases, the rapid temperature increase no longer occurs even when the droplets fall into the heel. In FIG. 4, the angle $\theta j$ formed by an inclination of a graph in the period Nj and an inclination of the graph in the period SPj decreases with time (as j increases).

Therefore, by predicting the change of the 0% position liquid temperature before and after the spray operation by the spray limit index SLI as described above, it is possible to predict the heel stored in the heel tanks $103_2$ and $103_3$ becoming heavier. In the present embodiment, as described above, dT2/dt, which is the change in temperature (inclination in the graph of FIG. 4) in the period SPj of each spray operation is compared with dT1/dt, which is the change in temperature (inclination in the graph of FIG 4) in the period Nj before performing each spray operation

In FIG 4, because the temperature changes substantially linearly in each of the periods Nj and SPj, the change in temperature (inclination of the graph) in each of the periods Nj and SPj is substantially constant However, FIG 4 is merely an example, and a temporal change in the 0% position liquid temperature is not always a linear change. Therefore, it may be preferable to compare the change in temperature immediately after the spray operation is performed with the change in temperature immediately before the spray operation is performed.

The assessment unit 433 assesses whether or not the spray limit index SLI falls outside a prescribed range. In the present embodiment, when SLI = dT2/dt - dT1/dt < a, the assessment unit 433 assesses that the spray limit index SLI falls outside the prescribed range. A threshold value $\alpha$ is set to, for example, 0 or a value close to 0. When the spray limit index SLI falls outside the range before arrival at the arrival place in the simulation, the assessment unit 433 assesses that the cooling effect of the tank by the spray operation of the spray mechanism is at the limit.

When the spray limit index SLI falls outside the range before arrival at the arrival place in the simulation, the simulation execution unit 431 changes the subsequent operation mode of the spray mechanism 700 and continues the simulation. For example, as in the present embodiment, when the spray mechanism 700 is configured to supply the LNG to be sprayed in each tank $103_i$ from one of at least two heel tanks $103_2$ and $103_3$, and when the spray limit index SLI falls outside the range before arrival at the arrival place in the simulation, the simulation execution unit 431 may switch the heel tank being the supply source of the LNG to be sprayed in each tank $103_i$ to another heel tank and continue the simulation.

For example, when the heel tank $103_2$ is initially used as the supply source of LNG to be sprayed, when the spray limit index SLI falls outside the range, the liquid temperature (0% position liquid temperature) of another heel tank $103_3$ is obtained, and when the liquid temperature thereof is lower than that of the heel tank $103_2$ serving as the current supply source, the heel tank used as the supply source of LNG may be switched from the tank $103_2$ to the tank $103_3$.

When there are plural heel tanks, and when the spray limit index SLI in the heel tank $103_2$ serving as the supply source of the spray operation falls outside the range, the supply source of LNG for the spray operation is switched to another heel tank $103_3$. With this, the spray operation is continued.

According to the above configuration, by calculating the spray limit index SLI based on the change in liquid temperature at the bottom of the tank before and after the spray operation is performed in the tank $103_i$ criteria for determining the degree of heaviness of heel and the cooling limit of the tank $103_i$ by the spray operation can be quantified. In the present embodiment, the case in which the change in temperature dT2/dt after the spray operation and the change in temperature dT1/dt before the spray operation are substantially equal is assessed to be the spray limit (spraying does not any longer contribute to cooling of the tank $103_i$). This makes it possible to easily perform the prediction calculation of the operation performed using LNG during the ballast voyage of the LNG carrying vessel 100.

Note that the change in the operation mode of the spray mechanism 700 is not limited to the above-described switching of the heel tank serving as the supply source. For example, the simulation execution unit 431 may continue the simulation by changing the amount of spraying and/or interval of spraying in the spray mechanism 700.

Further, when the spray limit index SLI falls outside the range before arrival at the arrival place in the simulation, the simulation execution unit 431 may re-execute the simulation after the initial amount of heel is increased.

Further, the change of the operation mode and the change of the initial amount of heel may be combined. For example, the assessment device 1 may first perform the simulation by setting the heel tank $103_2$ as the supply source of LNG to be sprayed, and when the spray limit index SLI falls outside the range, the simulation may be continued after the supply source of LNG is switched from the heel tank $103_2$ to the heel tank $103_3$, and when the spray limit index SLI falls outside the range again, the simulation may be performed again after the initial amount of heel is increased.

The initial amount of heel may be increased by an amount calculated by the simulation, or by a prescribed amount When the prescribed amount is set, the simulation execution unit 431 increases the initial amount of heel by the prescribed amount each time the spray limit index SLI falls outside the range in the simulation, and repeats the simulation. For example, the minimum initial amount of heel in the case when the simulation ends with the spray limit index SLI remaining within the range until the arrival place of the ballast voyage, is output from the output portion 5 as the initial amount of heel necessary for the spray operation of the ballast voyage.

[Effect assessment processing related to fuel supply operation]

Next, the effect assessment processing regarding the fuel supply operation is described. As described above, in the present embodiment, the assumed LNG carrying vessel 100 has the premixed combustion gas engine 102 that can use the liquefied gas stored in the tank as fuel. The simulation execution unit 431 predicts and calculates a change in the amount of heel caused by supplying the engine 102 with fuel.

Then, the methane number calculation unit 434 calculates the change in composition of the boil-off gas in the tank $103_i$ and the LNG stored in the tank $103_i$ after the spraying of the LNG by the spray mechanism 700, and calculates a methane number of the LNG In the present embodiment, the methane number calculation unit 434 calculates the change in composition of the boil-off gas in the heel tanks $103_2$ and $103_3$ and the LNG stored in the heel tanks $103_2$ and $103_3$, which serve as the supply source of boil-off gas and LNG to the engine 102, and calculates the methane number of the boil-off gas and the LNG

First, a mode of calculating the change in composition of boil-off gas and LNG is described. In the mixed composition of LNG, it is assumed that methane is C1, ethane is C2, propane is C3, butane is C4, and nitrogen is N2. Further, it is assumed that a weight of heel stored in the tank $103_i$ is $G_{heel}$, a heel liquid temperature is T, and a tank pressure is P. Heel composition ratios ($R_{Ghc1}$, $R_{Ghc2}$, $R_{Ghc3}$, $R_{Ghc4}$, $R_{GhN2}$) at this time are assumed to be known. In the following, the calculation is performed assuming that the LNG is composed of five types of compositions. However, the same calculation can be performed even when some of these components are not included or when other components are included.

Among the droplets sucked by the pump 310 from the heel tanks $103_2$ and $103_3$ and sprayed from the spray nozzle 740 into the tank $103_i$, assuming that a weight of the droplets that boil off and become the boil-off gas is $G_{sg}$ and a weight of the droplets that remain without boiling off is $G_{sl}$, a mass fraction (quality) x of the sprayed droplet is represented by x = $G_{sg}/(G_{sg} + G_{s1})$. The quality x is obtained from the tank pressure P and the saturation temperature by calculating the thermophysical properties of the mixed composition. Assuming that the total weight of the sprayed droplets is $G_{spray}$ ($G_{spay} = G_{sg} + G_{sl}$), a boil-off amount W of the sprayed droplets is obtained as W=x$\times G_{spray}$.

The composition ratios ($R_{Wc1}$, $R_{Wc2}$, $R_{Wc3}$, $R_{Wc4}$, $R_{N2}$) of the boil-off gas in the sprayed droplets are obtained from the tank pressure P and the saturation temperature by calculating the thermophysical properties of the mixed composition.

From the boil-off amount w and the composition ratios of the boil-off gas ($R_{Wc1}$, $R_{Wc2}$, $R_{wc3}$, $R_{Wc4}$, $R_{N2}$), the boil-off amounts of respective compositions of the boil-off gas ($W_{c1}$), $W_{c2}$, $W_{c3}$, $W_{c4}$, $W_{N2}$ are obtained as $W_{c1} = W \times R_{Wc1}$, $W_{c2} = W \times R_{Wc2}$, $W_{c3} = W \times R_{Wc3}$, $W_{c4} = W \times R_{Wc4}$, $W_{N2} = W \times R_{WN2}$, respectively. Therefore, the amount of each of the compositions ($G_{rc1}$, $G_{rc2}$, $G_{rc3}$, $G_{rc4}$, $G_{rN2}$) of the droplets that could not completely boil off among the sprayed droplets is obtained by subtracting the boil-off amount of each composition from the amount of each composition of the sprayed droplets. That is, the amounts of respective compositions of the sprayed droplets ($G_{sc1}$, $G_{sc2}$, $G_{sc3}$, $G_{sc4}$, $G_{sN2}$) are $G_{sc1} = G_{spray} \times R_{Ghc1}$, $G_{sc2} = G_{spray} \times R_{Ghc2}$, $G_{sc3} = G_{spay} \times R_{Ghc3}$, $G_{sc4} = G_{spray} \times R_{Ghc4}$, $G_{sN2} = G_{spray} \times R_{GhN2}$, respectively. Therefore, the amount of respective compositions of the droplets that could not completely boil off can be obtained as $G_{rc1} = G_{sc1} - W_{c1}$, $G_{rc2} = G_{sc2} - W_{c2}$, $G_{rc3} = G_{sc3} - W_{c3}$, $G_{rc4} = G_{sc4} - W_{c4}$, $G_{rN2} = G_{sN2} - W_{N2}$, respectively. The total amount $G_{return}$ of the droplets that could not completely boil off is $G_{return} = G_{rc1} + G_{rc2} + G_{rc3} + G_{rc4} + G_{rN2}$.

The total amount of heel is reduced by the amount of spraying $G_{spray}$ used for the spray operation, and the total amount $G_{return}$ of the droplets that could not completely boil off returns as the heel. Accordingly, the amount of heel $G'_{heel}$ after the spray operation is $G'_{heel} = G_{heel} - G_{spray} + G_{return}$.

Therefore, the weights of respective compositions of the heel ($G'_{hc1}$, $G'_{hc2}$, $G'_{hc3}$, $G'_{hc4}$, $G'_{N2}$) after the spray operation are,

$$G'_{hc1} = (G_{heel} \times R_{Ghc1}) - (G_{spray} \times R_{Ghc1}) + (G_{sc1} - W_{c1}),$$

$$G'_{hc2} = (G_{heel} \times R_{Ghc2}) - (G_{spray} \times R_{Ghc2}) + (G_{sc2} - W_{c2}),$$

$$G'_{hc3} = (G_{heel} \times R_{Ghc3}) - (G_{spray} \times R_{Ghc3}) + (G_{sc3} - W_{c3}),$$

$$G'_{hc4} = (G_{heel} \times R_{Ghc4}) - (G_{spray} \times R_{Ghc4}) + (G_{sc4} - W_{c4}),$$

$$G'_{hN2} = (G_{heel} \times R_{GN2}) - (G_{spray} \times R_{GN2}) + (G_{sN2} - W_{N2}),$$

respectively.

From the amount of heel $G'_{heel}$ and the weights of respective compositions ($G'_{hcl}$, $G'_{hc2}$, $G'_{hc3}$, $G'_{hc4}$, $G'_{N2}$) after the spray operation, the ratios of respective compositions $R'_{Ghcl}$, $R'_{Ghc2}$, $R'_{Ghc3}$, $R_{Ghc4}$, and $R'_{GhN2}$ are obtained

The methane number calculation unit 434 calculates the respective composition ratios $R'_{Ghc1}$, $R'_{Ghc2}$, $R'_{Ghc3}$, $R'_{Ghc4}$, and $R'_{GhN2}$ after the spray operation by performing the above-described calculation. Further, the methane number calculation unit 434 calculates the methane number from the obtained composition ratios.

The methane number MN conforms to a motor octane number MON, and a conversion formula using the motor octane number MON is known. This conversion formula is given by, for example, MN = 1.445MON - 103.42. The value of the motor octane number MON is calculated using the composition ratios of LNG When the compositions of LNG are methane, ethane, propane, butane and nitrogen used in the calculation of the above composition ratios, MON is represented by, for example, MON = $137.78R'_{Ghc1}$ + $29.948R'_{Ghc2}$ - $18.193R'_{Ghc3}$ - $167.062R'_{Ghc4}$ + $26.994R'_{GhN2}$. Therefore, the methane number MN is obtained from each composition ratio after the spray operation.

The methane number calculation unit 434 calculates the methane number MN after the spray operation by performing the above-described calculation. The assessment unit 433 assesses whether or not the methane number of the heel and the boil-off gas falls outside a prescribed range. If the methane number MN falls outside the range, the assessment unit 433 assesses that the criteria is not met to supply the heel and the boil-off gas in the heel tanks $103_2$ and $103_3$, serving as the supply source to the engine 102, to the premixed combustion gas engine.

In the simulation, when the methane number MN falls outside the prescribed range before arrival at the arrival place, the simulation execution unit 431 changes a subsequent supply mode of LNG to the engine 102 and continues the simulation, or increases the amount of heel and re-executes the simulation.

The change of the supply mode of LNG includes, for example, at least one of switching of the heel tanks $103_2$ and $103_3$ serving as the supply source, stopping of the LNG supply operation to the engine 102, and changing of the amount of LNG supply to the engine 102. Further, in addition to or instead of this, when the simulation is reexecuted by increasing the initial amount of heel, the simulation execution unit 431 executes the same processing as the effect assessment processing regarding the spray operation.

According to the above-described mode, by calculating the amount of composition change of the heel and the boil-off gas, the methane number of the heel and the boil-off gas can be calculated. This makes it possible to easily assess whether or not the LNG in the tank $103_i$ can be used as fuel for the premixed combustion gas engine.

The optimum operation plan is calculated by incorporating the prediction calculation considering the above-described two effect assessment results. Accordingly, the amount of loaded heel (initial amount of heel) during the ballast voyage can be minimized considering the viewpoints of cooling control of the tank $103_i$ by spray operation and control of fuel supply to the engine 102. Therefore, it is possible to maximize the amount of unloaded LNG while ensuring safe navigation of the LNG carrying vessel 100.

[Modification]

As described above, the embodiment of the present invention has been described, however, the present invention is not limited to the above embodiment, and various improvements, changes, and modifications can be made without departing from the gist of the present invention.

For example, in the above-described embodiment, the assessment device 1 has been described in which both of the effect assessment processing related to the spray operation and the effect assessment processing related to the fuel supply operation can be executed. However, the present invention is not limited to this, and each of the effect assessment processing may be executed independently. That is, the assessment device 1 may be configured as a device that can execute only one of the effect assessment processing related to the spray operation and the effect assessment processing related to the fuel supply operation. In other words, the assessment device 1 that can execute the effect assessment processing related to the spray operation may not include the methane number calculation unit 434, and the assessment device 1 that can execute the effect assessment processing related to the fuel supply operation may not include the spray limit index calculation unit 432.

Further, in the above-described embodiment, the description has been made assuming that the effect assessment processing is executed before departure of the LNG carrying vessel 100. However, the above-described mode can be executed not only before departure of the LNG carrying vessel 100, but also after departure of the LNG carrying vessel 100. In this case, the current position or future position (scheduled navigation position) of the LNG carrying vessel 100 becomes the departure place.

Further, the assessment device 1 is not limited to the mode of assessing the effect of the spray operation based on the prediction calculation of the spray operation. That is, in the above-described embodiment, the mode has been described in which the spray limit index calculation unit 432, the assessment unit 433, and the methane number calculation unit 434 are provided as functional blocks of the prediction calculation section 43 of the assessment device 1. However, the present invention is not limited to this. In other words, the spray limit index calculation unit 432, the assessment unit 433, and the methane number calculation unit 434 may be function blocks independent of the prediction calculation section 43. In this case, the assessment device 1 may not include the prediction calculation section 43 (simulation execution unit 431).

For example, during the navigation of the LNG carrying vessel 100, the spray limit index SLI may be calculated based on the actual change in the 0% position liquid temperature. If the spray limit index SLI falls outside the prescribed range during the navigation, the assessment device 1 may output a prescribed output signal. This output signal may be a control signal input to a control device (not shown) of the LNG carrying vessel 100. For example, the above control signal includes a control signal for switching the heel tank $103_i$ serving as the supply source to another heel tank $103_i$, a control signal for stopping the subsequent spray operation, or the like.

Similarly, the assessment device 1 may calculate the methane number MN of the heel and the boil-off gas in the actual heel tanks $103_2$ and $103_3$ during the voyage of the LNG carrying vessel 100. For example, when the methane number MN falls outside the prescribed range during the navigation, a prescribed output signal may be output. This output signal may be a control signal input to a control device (not shown) of the LNG carrying vessel 100. For example, the above control signal includes a control signal for switching the heel tank $103_i$ serving as the supply source to another heel tank $103_i$ a control signal for stopping the subsequent LNG supply operation to the engine 102 and switching the fuel to be supplied to the engine 102 to liquid fuel, or the like.

Further, in the above-described embodiment, the configuration has been exemplified in which the assessment device 1 includes the optimum route calculation section 42 that executes the optimum route calculation processing. However, the assessment device 1 may not include the optimum route calculation section 42. For example, a configuration may be made in which a computer device mounted with plural applications such as a prediction calculation application and an optimum route calculation application executes each application, to thereby execute the optimum operation plan calculation as a whole.

Further, in the above-described embodiment, the LNG carrying vessel employing the propulsion system 900 of the DFD electric propulsion system is exemplified as the LNG carrying vessel 100 to be subjected to the operation effect assessment and the prediction calculation. However, the present invention is not limited thereto. For example, the above-described operation effect assessment and/or prediction calculation can be executed for an LNG carrying vessel having a mechanical propulsion system in which the propulsion device is directly driven by the output of the engine 102.

Further, in the above-described embodiment, the mode has been described in which the operation mode of the spray mechanism is changed when the value of the spray limit index SLI falls outside the prescribed range. However, the above-described embodiment does not prevent the operation mode from being changed before the value falls outside the prescribed range. Similarly, in the above-described embodiment, the mode has been described in which the supply mode of the liquefied gas to the premixed combustion gas engine is changed when the value of the methane number MN falls outside the prescribed range. However, the above-described embodiment does not prevent the supply mode from being changed before the methane number MN falls outside the prescribed range.

**Industrial Applicability**

The present invention is useful for providing an assessment device and an assessment method that can easily assess an effect of operation performed using liquefied gas during a ballast voyage of a liquefied gas carrying vessel.

**Reference Signs List**

| | |
|---|---|
| 1 | assessment device |
| 4 | calculation portion |
| 43 | prediction calculation section |
| 100 | liquefied gas (LNG) carrying vessel |
| 102 | engine (premixed combustion gas engine) |
| 103, $103_i$ | (i=1, 2,...) tank |
| 431 | simulation execution unit |
| 432 | spray limit index calculation unit |
| 433 | assessment unit |
| 434 | methane number calculation unit |

**Claims**

1. An assessment device (1) adapted to assess an effect of an operation performed using liquefied gas during a ballast voyage of a liquefied gas carrying vessel (100), the liquefied gas carrying vessel (100) including a tank (103) adapted to store liquefied gas, and a spray mechanism (700) adapted to suck a part of the liquefied gas in the tank (103) and performs spraying inside the tank (103), **characterized in that**
   the assessment device (1) comprises:

   a spray limit index calculation unit (432) adapted to calculate a spray limit index (SLI) based on a change in liquid temperature of the liquefied gas at a bottom of the tank (103), the change resulting from a spray operation performed by the spray mechanism (700); and
   an assessment unit (433) adapted to assess an effect of cooling of the tank (103) by the spray operation based on whether or not the spray limit index (SLI) falls outside a prescribed range,
   wherein the spray limit index calculation unit (432) calculates, as the spray limit index (SLI), a difference between an amount of change in liquid temperature per unit time of the liquefied gas before the spray operation of the liquefied gas and an amount of change in liquid temperature per unit time of the liquefied gas after the spray operation of the liquefied gas.

2. The assessment device (1) according to claim 1, comprising a simulation execution unit (431) adapted to execute, using an initial amount of heel indicating an amount of the liquefied gas stored in the tank (103) at a departure place of the ballast voyage, a simulation of a spray operation using the spray mechanism (700) in a route from the departure place to an arrival place of the ballast voyage,
   wherein, when the spray limit index (SLI) falls outside the range before arrival at the arrival place in the simulation, the simulation execution unit (431) is configured to continue the simulation after changing a subsequent operation mode of the spray mechanism.

3. The assessment device (1) according to claim 1 or 2, comprising a simulation execution unit (431) adapted to execute, using an initial amount of heel indicating an amount of the liquefied gas stored in the tank (103) at a departure place of the ballast voyage, a simulation of a spray operation using the spray mechanism (700) in a route from the departure place to an arrival place of the ballast voyage,
   wherein, when the spray limit index (SLI) falls outside the range before arrival at the arrival place in the simulation, the simulation execution unit (431) is configured to increase the initial amount of heel and re-execute the simulation.

4. The assessment device (1) according to any of claims 1 to 3, wherein

   the liquefied gas carrying vessel (100) includes a plurality of tanks (103), and at least one of the plurality of tanks (103) is a non-heel tank adapted to store only a minimum required amount of the liquefied gas during the ballast voyage, and
   the spray limit index calculation unit (432) calculates the spray limit index (SLI) based on a liquid temperature of the liquefied gas at a bottom of the non-heel tank.

5. The assessment device (1) according to any of claims 1 to 4, wherein

   the liquefied gas carrying vessel (100) include a plurality of tanks (103), and at least two of the plurality of tanks (103) are heel tanks adapted to store the liquefied gas used for navigation of the liquefied gas carrying vessel (100) in the ballast voyage,
   the spray mechanism (700) is configured to supply liquefied gas being sprayed in each tank from at least one of the at least two heel tanks, and
   when the spray limit index (SLI) falls outside the range, the heel tank as a supply source of the liquefied gas to be sprayed in each tank is switched to another heel tank.

6. The assessment device (1) according to any of claims 1 to 5, wherein, when the spray limit index (SLI) falls outside the range, the spray operation performed subsequently is stopped.

7. The assessment device (1) according to any of claims 1 to 6, wherein

   the liquefied gas carrying vessel (100) includes a premixed combustion gas engine (102) adapted to use the liquefied gas stored in the tank (103) as fuel,

the assessment device (1) includes a methane number calculation unit (434) adapted to calculate a composition change of the liquefied gas stored in the tank (103) and a boil-off gas in the tank (103) after the spray operation of the liquefied gas is performed using the spray mechanism (700), and calculates a methane number of the liquefied gas and the boil-off gas, and

the assessment unit (433) is configured to assess whether or not the methane number of the liquefied gas after the spray operation of the liquefied gas is performed falls outside a prescribed range.

**8.** The assessment device (1) according to claim 7, comprising a simulation execution unit (431) adapted to execute, using an initial amount of heel indicating an amount of the liquefied gas stored in the tank (103) at a departure place of the ballast voyage, a simulation of a spray operation using the spray mechanism (700) in a route from the departure place to an arrival place of the ballast voyage,

wherein, when the methane number falls outside the range before arrival at the arrival place in the simulation, the simulation execution unit (431) is configured to continue the simulation after changing a subsequent supply mode of the liquefied gas to the premixed combustion gas engine (102).

**9.** The assessment device (1) according to claim 7 or 8, comprising a simulation execution unit (431) adapted to execute, using an initial amount of heel indicating an amount of the liquefied gas stored in the tank (103) at a departure place of the ballast voyage, a simulation of a spray operation using the spray mechanism (700) in a route from the departure place to an arrival place of the ballast voyage,

wherein, when the methane number falls outside the range before arrival at the arrival place in the simulation, the simulation execution unit (431) is configured to increase the initial amount of heel and re-execute the simulation.

**10.** An assessment method of assessing an effect of an operation performed using liquefied gas during a ballast voyage of a liquefied gas carrying vessel (100), the liquefied gas carrying vessel (100) including a tank (103) adapted to store the liquefied gas, and a spray mechanism (700) adapted to suck a part of the liquefied gas inside the tank (103) and performs spraying inside the tank (103), **characterized in that**

the assessment method comprises:

a spray limit index calculation step of calculating a spray limit index (SLI) indicating a change in liquid temperature of the liquefied gas at a bottom of the tank (103), the change resulting from a spray operation performed by the spray mechanism (700); and

an assessment step of assessing an effect of cooling the tank (103) by the spray operation based on whether or not the spray limit index (SLI) falls outside a prescribed range

wherein the spray limit index calculation step includes calculating, as the spray limit index (SLI), a difference between an amount of change in liquid temperature per unit time of the liquefied gas before the spray operation of the liquefied gas and an amount of change in liquid temperature per unit time of the liquefied gas after the spray operation of the liquefied gas.

**Patentansprüche**

**1.** Beurteilungsvorrichtung (1), die zum Beurteilen einer Auswirkung eines unter Verwendung von Flüssiggas während einer Ballastreise eines Flüssiggastankers (100) durchgeführten Vorgangs angepasst ist, wobei der Flüssiggastanker (100) einen Tank (103) umfasst, der zum Speichern von Flüssiggas angepasst ist, und einen Sprühmechanismus (700) umfasst, der zum Ansaugen eines Teils des sich in dem Tank (103) befindenden Flüssiggases und zum Durchführen eines Sprühens im Inneren des Tanks (103) angepasst ist, **dadurch gekennzeichnet, dass**:

die Beurteilungsvorrichtung (1) ferner Folgendes umfasst:

eine Sprühgrenzenindex-Berechnungseinheit (432), die zum Berechnen eines Sprühgrenzenindex (SGI) basierend auf einer Änderung der Flüssigkeitstemperatur des Flüssiggases an einem Boden des Tanks (103) angepasst ist, wobei die Änderung aus einem Sprühvorgang resultiert, der durch den Sprühmechanismus (700) durchgeführt wird; und

eine Beurteilungsvorrichtung (433), die zum Beurteilen einer Auswirkung einer Kühlung des Tanks (103) durch den Sprühvorgang basierend darauf, ob der Sprühgrenzenindex (SGI) außerhalb eines vorgeschriebenen Bereichs fällt oder nicht, angepasst ist,

wobei die Sprühgrenzenindex-Berechnungseinheit (432) eine Differenz zwischen einem Änderungsbetrag der Flüssigkeitstemperatur pro Zeiteinheit des Flüssiggases vor dem Sprühvorgang des Flüssiggases und einem Änderungsbetrag der Flüssigkeitstemperatur pro Zeiteinheit des Flüssiggases nach dem Sprühvorgang des Flüssiggases als den Sprühgrenzenindex (SGI) berechnet.

2. Beurteilungsvorrichtung (1) nach Anspruch 1, die eine Simulationsausführungseinheit (431) umfasst, die dazu angepasst ist, eine Simulation eines Sprühvorgangs unter Verwendung des Sprühmechanismus (700) auf einer Route von einem Abfahrtsort zu einem Ankunftsort der Ballastreise auszuführen, und zwar unter Verwendung einer anfänglichen Mindestmenge, die eine Menge des Flüssiggases anzeigt, das an dem Abfahrtsort der Ballastreise in dem Tank (103) gespeichert ist,

wobei, wenn der Sprühgrenzenindex (SGI) in der Simulation vor der Ankunft an dem Ankunftsort aus dem Bereich fällt, die Simulationsausführungseinheit (431) dazu konfiguriert ist, die Simulation fortzusetzen, nachdem ein nachfolgender Betriebsmodus des Sprühmechanismus geändert wurde.

3. Beurteilungsvorrichtung (1) nach Anspruch 1 oder 2, die eine Simulationsausführungseinheit (431) umfasst, die dazu angepasst ist, eine Simulation eines Sprühvorgangs unter Verwendung des Sprühmechanismus (700) auf einer Route von einem Abfahrtsort zu einem Ankunftsort der Ballastreise auszuführen, und zwar unter Verwendung einer anfänglichen Mindestmenge, die eine Menge des Flüssiggases anzeigt, das an dem Abfahrtsort der Ballastreise in dem Tank (103) gespeichert ist,

wobei, wenn der Sprühgrenzenindex (SGI) in der Simulation vor der Ankunft an dem Ankunftsort aus dem Bereich fällt, die Simulationsausführungseinheit (431) dazu konfiguriert ist, die anfängliche Mindestmenge zu erhöhen und die Simulation erneut auszuführen.

4. Beurteilungsvorrichtung (1) nach einem der Ansprüche 1 bis 3, wobei:

der Flüssiggastanker (100) eine Vielzahl von Tanks (103) enthält und es sich bei mindestens einem aus der Vielzahl von Tanks (103) um einen Nicht-Mindestmengentank handelt, der dazu angepasst ist, nur eine minimal erforderliche Menge des Flüssiggases während der Ballastreise zu speichern, und die Sprühgrenzenindex-Berechnungseinheit (432) den Sprühgrenzenindex (SGI) basierend auf einer Flüssigkeitstemperatur des Flüssiggases an einem Boden des Nicht-Mindestmengentanks berechnet.

5. Beurteilungsvorrichtung (1) nach einem der Ansprüche 1 bis 4, wobei:

der Flüssiggastanker (100) eine Vielzahl von Tanks (103) enthält und es sich bei mindestens zwei aus der Vielzahl von Tanks (103) um Mindestmengentanks handelt, die dazu angepasst sind, um das Flüssiggas zu speichern, das für die Navigation des Flüssiggastankers (100) auf der Ballastreise verwendet wird, der Sprühmechanismus (700) dazu konfiguriert ist, Flüssiggas, das in jedem Tank versprüht wird, von mindestens einem der mindestens zwei Mindestmengentanks zuzuführen, und wenn der Sprühgrenzenindex (SGI) außerhalb des Bereichs fällt, der Mindestmengentank als eine Zufuhrquelle des in jedem Tank zu versprühenden Flüssiggases zu einem anderen Mindestmengentank umgeschaltet wird.

6. Beurteilungsvorrichtung (1) nach einem der Ansprüche 1 bis 5, wobei, wenn der Sprühgrenzenindex (SGI) außerhalb des Bereichs fällt, der anschließend durchgeführte Sprühvorgang gestoppt wird.

7. Beurteilungsvorrichtung (1) nach einem der Ansprüche 1 bis 6, wobei:

der Flüssiggastanker (100) einen Vormischungsgas-Verbrennungsmotor (102) enthält, der so angepasst ist, dass er das in dem Tank (103) gespeicherte Flüssiggas als Brennstoff verwendet, die Beurteilungsvorrichtung (1) eine Methanzahl-Berechnungseinheit (434) umfasst, die dazu angepasst ist, eine Zusammensetzungsänderung des in dem Tank (103) gespeicherten Flüssiggases und eines sich in dem Tank (103) befindenden Abdampfgases zu berechnen, nachdem der Sprühvorgang des Flüssiggases unter Verwendung des Sprühmechanismus (700) durchgeführt wurde, und eine Methanzahl des Flüssiggases und des Abdampfgases zu berechnen, und die Beurteilungsvorrichtung (433) so konfiguriert ist, dass sie bewertet, ob die Methanzahl des Flüssiggases, nachdem der Sprühvorgang des Flüssiggases durchgeführt wurde, außerhalb eines vorgeschriebenen Bereichs fällt oder nicht.

8. Beurteilungsvorrichtung (1) nach Anspruch 7, die eine Simulationsausführungseinheit (431) umfasst, die dazu angepasst ist, eine Simulation eines Sprühvorgangs unter Verwendung des Sprühmechanismus (700) auf einer Route von einem Abfahrtsort zu einem Ankunftsort der Ballastreise auszuführen, und zwar unter Verwendung einer anfänglichen Mindestmenge, die eine Menge des Flüssiggases anzeigt, das an dem Abfahrtsort der Ballastreise in dem Tank (103) gespeichert ist,

wobei, wenn die Methanzahl in der Simulation vor der Ankunft an dem Ankunftsort aus dem Bereich fällt, die Simulationsausführungseinheit (431) dazu konfiguriert ist, die Simulation fortzusetzen, nachdem ein nachfolgender Zufuhrmodus des Flüssiggases zu dem Vormischungsgas-Verbrennungsmotor (102) geändert wurde.

**9.** Beurteilungsvorrichtung (1) nach Anspruch 7 oder 8, die eine Simulationsausführungseinheit (431) umfasst, die dazu angepasst ist, eine Simulation eines Sprühvorgangs unter Verwendung des Sprühmechanismus (700) auf einer Route von einem Abfahrtsort zu einem Ankunftsort der Ballastreise auszuführen, und zwar unter Verwendung einer anfänglichen Mindestmenge, die eine Menge des Flüssiggases anzeigt, das an dem Abfahrtsort der Ballastreise in dem Tank (103) gespeichert ist,

wobei, wenn die Methanzahl in der Simulation vor der Ankunft an dem Ankunftsort aus dem Bereich fällt, die Simulationsausführungseinheit (431) dazu konfiguriert ist, die anfängliche Mindestmenge zu erhöhen und die Simulation erneut auszuführen.

**10.** Verfahren zur Beurteilung einer Auswirkung eines unter Verwendung von Flüssiggas während einer Ballastreise eines Flüssiggastankers (100) durchgeführten Vorgangs, wobei der Flüssiggastanker (100) einen Tank (103) umfasst, der zum Speichern des Flüssiggases angepasst ist, und einen Sprühmechanismus (700) umfasst, der zum Ansaugen eines Teils des Flüssiggases im Inneren des Tanks (103) und zum Durchführen eines Sprühens im Inneren des Tanks (103) angepasst ist, **dadurch gekennzeichnet, dass**:

das Beurteilungsverfahren Folgendes umfasst:

eine Sprühgrenzenindex-Berechnungsschritt zum Berechnen eines Sprühgrenzenindex (SGI), der eine Änderung der Flüssigkeitstemperatur des Flüssiggases an einem Boden des Tanks (103) anzeigt, wobei die Änderung aus einem Sprühvorgang resultiert, der durch den Sprühmechanismus (700) durchgeführt wird; und einen Beurteilungsschritt zum Beurteilen einer Auswirkung einer Kühlung des Tanks (103) durch den Sprühvorgang basierend darauf, ob der Sprühgrenzenindex (SGI) außerhalb eines vorgeschriebenen Bereichs fällt oder nicht,

wobei der Sprühgrenzenindex-Berechnungsschritt beinhaltet, eine Differenz zwischen einem Änderungsbetrag der Flüssigkeitstemperatur pro Zeiteinheit des Flüssiggases vor dem Sprühvorgang des Flüssiggases und einem Änderungsbetrag der Flüssigkeitstemperatur pro Zeiteinheit des Flüssiggases nach dem Sprühvorgang des Flüssiggases als den Sprühgrenzenindex (SGI) zu berechnen.

**Revendications**

**1.** Dispositif d'évaluation (1) qui évalue l'effet d'une opération réalisée au moyen de gaz liquéfié au cours d'un voyage sur lest d'un méthanier (100), le méthanier (100) comportant une cuve (103) apte à contenir du gaz liquéfié, et un mécanisme de vaporisation (700) apte à aspirer une partie du gaz liquéfié présent dans la cuve (103) et à réaliser une vaporisation à l'intérieur de la cuve (103), **caractérisé en ce que** :

le dispositif d'évaluation (1) comprend :

une unité de calcul d'indice limite de vaporisation (432) apte à calculer un indice limite de vaporisation (ILV) compte tenu d'un changement de température à l'état liquide du gaz liquéfié au fond de la cuve (103), le changement étant dû à une opération de vaporisation réalisée par le mécanisme de vaporisation (700), et une unité d'évaluation (433) apte à évaluer l'effet d'un refroidissement de la cuve (103) assuré par l'opération de vaporisation compte tenu du fait ou non que l'indice limite de vaporisation (ILV) se retrouve en dehors d'une plage prescrite ;

ladite unité de calcul d'indice limite de vaporisation (432) calcule, comme indice limite de vaporisation (ILV), la différence entre le taux de changement de température du gaz à l'état liquide par unité de temps existant avant l'opération de vaporisation du gaz liquéfié et le taux de changement de température du gaz à l'état liquide par unité de temps existant après l'opération de vaporisation du gaz liquéfié.

**2.** Dispositif d'évaluation (1) selon la revendication 1, comprenant une unité d'exécution de simulation (431) apte à exécuter, au moyen d'une quantité initiale de talon indiquant la quantité de gaz liquéfié contenu dans la cuve (103) au lieu de départ du voyage sur lest, la simulation d'une opération de vaporisation mettant en œuvre le mécanisme de vaporisation (700) sur un trajet allant du lieu de départ au lieu d'arrivée du voyage sur lest,

étant entendu que, lorsque l'indice limite de vaporisation (ILV) se retrouve en dehors de la plage avant l'arrivée au lieu d'arrivée dans le cadre de la simulation, l'unité d'exécution de simulation (431) est conçue pour continuer la simulation après un changement du mode d'opération subséquent du mécanisme de vaporisation.

3. Dispositif d'évaluation (1) selon la revendication 1 ou 2, comprenant une unité d'exécution de simulation (431) apte à exécuter, au moyen d'une quantité initiale de talon indiquant la quantité de gaz liquéfié contenu dans la cuve (103) au lieu de départ du voyage sur lest, la simulation d'une opération de vaporisation mettant en œuvre le mécanisme de vaporisation (700) sur un trajet allant du lieu de départ au lieu d'arrivée du voyage sur lest, étant entendu que, lorsque l'indice limite de vaporisation (ILV) se retrouve en dehors de la plage avant l'arrivée au lieu d'arrivée dans le cadre de la simulation, l'unité d'exécution de simulation (431) est conçue pour augmenter la quantité initiale de talon et réexécuter la simulation.

4. Dispositif d'évaluation (1) selon l'une quelconque des revendications 1 à 3, dans lequel :

le méthanier (100) comporte une pluralité de cuves (103), et au moins une cuve de la pluralité de cuves (103) est une cuve sans talon apte à contenir uniquement une quantité minimum requise de gaz liquéfié au cours du voyage sur lest, et
l'unité de calcul d'indice limite de vaporisation (432) calcule l'indice limite de vaporisation (ILV) compte tenu de la température à l'état liquide du gaz liquéfié au fond de la cuve sans talon.

5. Dispositif d'évaluation (1) selon l'une quelconque des revendications 1 à 4, dans lequel :

le méthanier (100) comporte une pluralité de cuves (103), et au moins deux cuves de la pluralité de cuves (103) sont des cuves à talon aptes à contenir le gaz liquéfié servant à la navigation du méthanier (100) au cours du voyage sur lest,
le mécanisme de vaporisation (700) est conçu pour fournir du gaz liquéfié vaporisé dans chaque cuve à partir d'au moins une des au moins deux cuves à talon, et
lorsque l'indice limite de vaporisation (ILV) se retrouve en dehors de la plage, la cuve à talon servant de source d'alimentation en gaz liquéfié à vaporiser dans chaque cuve passe à une autre cuve à talon.

6. Dispositif d'évaluation (1) selon l'une quelconque des revendications 1 à 5, dans lequel, lorsque l'indice limite de vaporisation (ILV) se retrouve en dehors de la plage, l'opération de vaporisation réalisée subséquemment est arrêtée.

7. Dispositif d'évaluation (1) selon l'une quelconque des revendications 1 à 6, dans lequel :

le méthanier (100) comporte un moteur à combustion à gaz prémélangé (102) apte à utiliser le gaz liquéfié contenu dans la cuve (103) comme combustible,
ledit dispositif d'évaluation (1) comporte une unité de calcul d'indice de méthane (434) apte à calculer un changement de composition du gaz liquéfié contenu dans la cuve (103) et des évaporations présentes dans la cuve (103) après que l'opération de vaporisation du gaz liquéfié a été réalisée au moyen du mécanisme de vaporisation (700), et à calculer l'indice de méthane du gaz liquéfié et des évaporations, et
l'unité d'évaluation (433) est conçue pour évaluer si l'indice de méthane du gaz liquéfié après que l'opération de vaporisation du gaz liquéfié a été réalisée se retrouve ou non en dehors d'une plage prescrite.

8. Dispositif d'évaluation (1) selon la revendication 7, comprenant une unité d'exécution de simulation (431) apte à exécuter, au moyen d'une quantité initiale de talon indiquant la quantité de gaz liquéfié contenu dans la cuve (103) au lieu de départ du voyage sur lest, la simulation d'une opération de vaporisation mettant en œuvre le mécanisme de vaporisation (700) sur un trajet allant du lieu de départ à un lieu d'arrivée du voyage sur lest, étant entendu que, lorsque l'indice de méthane se retrouve en dehors de la plage avant l'arrivée au lieu d'arrivée dans le cadre de la simulation, l'unité d'exécution de simulation (431) est conçue pour continuer la simulation après un changement du mode d'alimentation subséquent en gaz liquéfié auprès du moteur à combustion à gaz prémélangé (102).

9. Dispositif d'évaluation (1) selon la revendication 7 ou 8, comprenant une unité d'exécution de simulation (431) apte à exécuter, au moyen d'une quantité initiale de talon indiquant la quantité de gaz liquéfié contenu dans la cuve (103) au lieu de départ du voyage sur lest, la simulation d'une opération de vaporisation mettant en œuvre le mécanisme de vaporisation (700) sur un trajet allant du lieu de départ à un lieu d'arrivée du voyage sur lest, étant entendu que, lorsque l'indice de méthane se retrouve en dehors de la plage avant l'arrivée au lieu d'arrivée dans le cadre de la simulation, l'unité d'exécution de simulation (431) est conçue pour augmenter la quantité initiale de talon et réexécuter la simulation.

10. Procédé d'évaluation consistant à évaluer l'effet d'une opération réalisée au moyen de gaz liquéfié au cours d'un voyage sur lest d'un méthanier (100), le méthanier (100) comportant une cuve (103) apte à contenir le gaz liquéfié, et un mécanisme de vaporisation (700) apte à aspirer une partie du gaz liquéfié présent à l'intérieur de la cuve (103) et à réaliser une vaporisation à l'intérieur de la cuve (103), **caractérisé en ce que** :

le procédé d'évaluation comprend :

une étape de calcul d'indice limite de vaporisation consistant à calculer un indice limite de vaporisation (ILV) indiquant un changement de température à l'état liquide du gaz liquéfié au fond de la cuve (103), le changement étant dû à une opération de vaporisation réalisée par le mécanisme de vaporisation (700), et

une étape d'évaluation consistant à évaluer l'effet d'un refroidissement de la cuve (103) assuré par l'opération de vaporisation compte tenu du fait ou non que l'indice limite de vaporisation (ILV) se retrouve en dehors d'une plage prescrite ;

ladite étape de calcul d'indice limite de vaporisation comportant le calcul, comme indice limite de vaporisation (ILV), d'une différence entre le taux de changement de température du gaz à l'état liquide par unité de temps existant avant l'opération de vaporisation du gaz liquéfié et le taux de changement de température du gaz à l'état liquide par unité de temps existant après l'opération de vaporisation du gaz liquéfié.

[FIG. 1]

1

2                                        3

| Input portion |        | Storage portion |

                                                          4

| Output portion |

                                   Calculation portion

                                   | Information input reception section | — 41

                                   | Optimum route calculation section | — 42

                          5

                                   | Prediction calculation section | — 43

                                   | Simulation execution unit | — 431

                                   | Spray limit index calculation unit | — 432

                6

                                   | Assessment unit | — 433

                                   | Methane number calculation unit | — 434

[FIG. 2]

                                        910

                                   102    912                    930

100                                                      931  932  933

           110

960

104                    E / G      ⓖ                 Ⓜ   | |  ⊲

                       E / G      ⓖ             | |

                       E / G      ⓖ                 Ⓜ

                       E / G      ⓖ                          931

                                   970         921    922

103        830        950              900      920

[FIG. 3]

[FIG. 4]

**EP 3 677 498 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015175488 A